# EUROPEAN PATENT SPECIFICATION

(11) **EP 3 516 190 B1**
(45) Date of publication and mention of the grant of the patent: **29.07.2020**
(21) Application number: 17771842.6
(22) Date of filing: 13.09.2017
(51) Int. Cl.: F02D 11/02, B60K 26/02, B60T 13/74

(54) **PEDAL ASSEMBLY PIEZOELECTRIC GENERATOR**
PIEZOELEKTRISCHER GENERATOR FÜR PEDALANORDNUNG
GÉNÉRATEUR PIÉZOÉLECTRIQUE D'ENSEMBLE PÉDALE

(30) Priority: 22.09.2016 GB 201616162
(43) Date of publication of application: 31.07.2019
(73) Proprietor: Arrival Limited, London W14 8TS (GB)
(72) Inventor: IRINICS, Aleksejs, Banbury Oxfordshire OX16 2SN (GB)
(74) Representative: Korenberg, Alexander Tal
(86) International application number: PCT/GB2017/052694
(87) International publication number: WO 2018/055337

(56) References cited:
- EP-A1- 1 695 882
- DE-A1- 19 738 183
- DE-A1-102008 001 522
- DE-A1-102008 012 874
- DE-A1-102011 118 365
- US-A1- 2012 299 443

## Description

### Technical Field

This specification relates to a pedal assembly for generating electric power in a vehicle.

### Background

Pedals are often used in automobiles or other types of road vehicles for controlling components of the vehicle. Examples of such components include a throttle, one or more brakes and/or a clutch. Conventionally, pressure exerted by a foot of an operator on a pedal is transmitted to the components for operation via mechanical or hydraulic systems. Such systems may, for example, include pumps, fluids, belts, cables, cylinders and/or vacuum servos. Recently, so called drive-by-wire technology has begun to replace these conventional systems. Using the drive-by-wire technology, the operator can control the vehicle functions such as clutch, brakes and throttle mainly by electrical control. Also in aviation industries, the term 'fly-by-wire technology' refers in general to the electrical control of brake, steering and throttle (thrust), flight control (yaw, pitch, roll).

Although drive-by-wire technology only requires electrical control, the conventional form of a pedal is still commonly used in vehicles. This is partly because the conventional components and systems referred to above still co-exist in the commercial market, often alongside equivalents using drive-by-wire technology. Also in many cases, drive-by-wire technology is used to only supplement part of the conventional technology. Therefore, human-machine interfaces such as pedal-feel emulators have been developed for compatibility of operation.

DE 10 2008 012874 describes a method involving determining height of a driver braking command during braking actuation. An available space of a piezoelectric expandable device (50) is changed in dependence of the driver braking command and based on a characteristic line. Elasticity of a vehicle braking system is partially compensated by the change of the available space of the expandable device. The driver braking command is determined based on a measured pedal force and on a motor torque of an electromechanical brake force booster (30) by a pressure sensor (60) or pedal force sensor (37) or path sensor.

US 2012/299443 describes an apparatus in which, when a rotating shaft member rotates, centrifugal force acts upon pressure members 152ⱼₖ (j=1,...,J; k=1,...,6) that are 1fixed to the rotating shaft member. When centrifugal force acts upon a pressure member 152ⱼₖ, an other end portion of a second bar shaped member that is connected to a first bar shaped member shifts in the direction to approach a pressure transmission member, and a contact member that is connected to the other end portion of the second bar shaped member presses against the pressure transmission member. When the pressure transmission member 130 is pressed in this manner, this pressure is applied against a piezoelectric element of an individual power generation part 122ⱼₚ that abuts in the radial direction against the pressure transmission member at the position of pressure. When pressure is applied to the piezoelectric element in this manner, the piezoelectric element continually and repeatedly generates a voltage.

### Summary

This specification provides a pedal assembly for generating electrical power in a vehicle, comprising a pedal which comprises a pad and a push element, the pedal configured to mechanically transfer pressure exerted on the pad to the push element to cause motion of the push element. The pedal assembly further comprises a motion conversion apparatus which comprises a shaft and a rotatable cylinder. The motion conversion apparatus is configured, in response to the motion of the push element, to generate a linear motion of the shaft along a longitudinal direction of the shaft. The motion conversion apparatus is further configured, in response to the linear motion of the shaft, to rotate the rotatable cylinder about the shaft. The pedal assembly further comprises a generation apparatus for generating voltage comprising a piezoelectric transducer. The rotatable cylinder is configured to apply mechanical stress on the piezoelectric transducer at least one predetermined angular position of the rotatable cylinder.

The rotatable cylinder of the pedal assembly may further comprise a plurality of protrusions positioned at the predetermined angular position along a circumference of the rotatable cylinder

The generation apparatus of the pedal assembly may further comprise a press element. The protrusions may be configured to be in mechanical contact with the press element at the predetermined angular positions of the rotatable cylinder such that the press element applies mechanical stress on the piezoelectric transducer when the at least one of the protrusions is in mechanical contact with the press element.

The generation apparatus of the pedal assembly may further comprise a first resilient apparatus configured to bring the press element back to a default position when the protrusions are not in mechanical contact with the press element.

The protrusions of the pedal assembly may be configured to be in mechanical contact with the piezoelectric transducer at the predetermined angular positions such that the protrusions apply mechanical stress on the piezoelectric transducer when at least one of the protrusions is in mechanical contact with the piezoelectric transducer.

In the pedal assembly, the predetermined angular positions of the protrusions around the circumference of the rotatable cylinder may be substantially uniformly spaced such that the voltage generated by the generation apparatus oscillates.

In the pedal assembly, a period of oscillation of the generated voltage maybe dependent on the predetermined angular positions of the protrusions and a frequency of rotation of the rotatable cylinder.

In the pedal assembly, the rotatable cylinder may further comprise a first helical raceway and the shaft may further comprise a second helical raceway. The motion conversion apparatus may further comprise a plurality of bearings which are arranged to be disposed between the first and second helical raceways. The rotatable cylinder may be arranged to rotate in response to linear motion of the shaft in cooperation with the plurality of bearings guided by the first and second raceways.

In the pedal assembly, the plurality of bearings may comprise ball bearings, or high super-precision bearings, or angular contact ball bearings.

In the pedal assembly, the plurality of bearings may comprise roller bearings.

The pedal assembly may further comprise a housing. The piezoelectric transducer may be fixed to the housing.

In the piezoelectric generator, the housing may further comprise third and fourth raceways; and the rotatable cylinder may further comprise fifth and sixth raceways on an exterior of the rotatable cylinder. Ball bearings may be disposed and held between the third and fifth raceways and fourth and sixth raceways, respectively, such that the motion of the rotatable cylinder is guided to be rotational with respect to the housing.

In the pedal assembly, the piezoelectric transducer may comprise a stack of multiple layers of piezoelectric material.

In the pedal assembly, the mechanical stress on the piezoelectric transducer may comprise mechanical compression.

In the pedal assembly, the mechanical stress on the piezoelectric transducer may comprise mechanical strain.

The pedal assembly may further comprise a harvesting circuit, which comprises a rectifier and a capacitor.

The pedal assembly may further comprise a second resilient apparatus configured to bring the pad back to a default position when no pressure is exerted on the pad.

### Brief Description of the Drawings

Embodiments of the present invention will now be described, by way of example only, with reference to the accompanying drawings, in which:
Fig. 1 shows a schematic of a pedal assembly apparatus;
Fig. 2a shows a schematic of a motion conversion unit connected to the pedal assembly apparatus;
Fig. 2b shows an exemplary arrangement of a shaft and a rotatable cylinder to enable motion conversion;
Fig. 3a and 3b show a schematic of a generation unit in conjunction with a motion conversion apparatus;
Fig. 3c shows an exemplary embodiment of a piezo-transducer;
Fig. 3d shows an exemplary embodiment of a harvesting circuit;
Fig. 4 shows a schematic of a housing in combination with a motion conversion apparatus and a generation apparatus;

### Detailed Description

In cases where drive-by-wire technology is used in a vehicle, the energy of the operator's motion to operate a pedal is not actually put into use for operating the corresponding components of the vehicle. For example, in the case of a brake-by-wire system, the energy exerted on the brake pedal by the driver of the vehicle is not used to directly actuate the brakes. Even in conventional pedal systems not using drive-by-wire technology, the energy of the operator's motion to operate the pedal cannot be entirely put into use for operating the corresponding components of the vehicle.

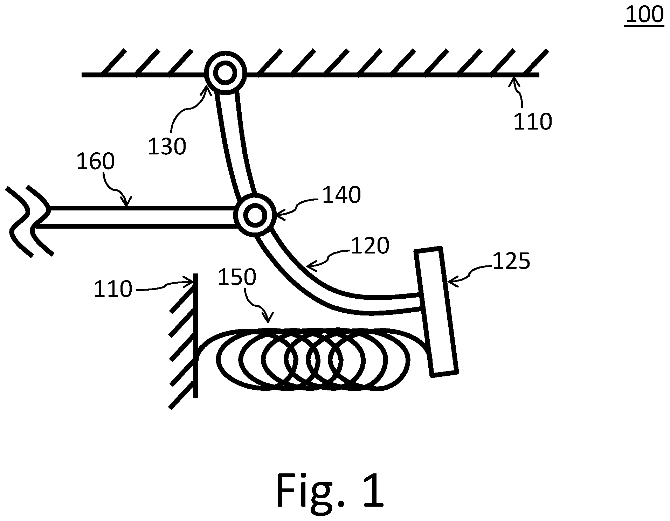

Fig. 1 shows the schematic of a pedal assembly apparatus 100. The pedal assembly apparatus 100 comprises a pedal support 110, a pedal body 120, a pad 125, a first pivot 130, a second pivot 140, a spring 150 and a push rod 160. The pedal assembly apparatus 100 may comprise further features depending on the application. If the pedal assembly apparatus 100 is used for a road vehicle, the pedal support 110 may be fixed within the road vehicle or be a part of the road vehicle such as the whole or part of a pedal box frame, or a body-in-white. The pedal assembly apparatus 100 maybe arranged such that when a user depresses the pad 125, the corresponding pressure may be mechanically transferred to the push rod 160. This mechanical transfer of pressure may be achieved as the first pivot 130 and the second pivot 140 turn, i.e. as the pedal body 120 pivots about the first pivot 130 and the push rod 160 pivots about the second pivot 140. As a result, the push rod 160 may be used to exert an amount of pressure desired by the user on one or more elements connected to the push rod 160. The elements connected to the push rod 160 may include components for controlling acceleration, braking and/or clutch operation within a road vehicle, although the elements are not limited to these examples.

When a user releases depression from the pad 125, the pedal assembly apparatus 100 may be arranged to return to its original position with the help of the restoring force from the spring 150. In place of the spring 150, any other appropriate resilient elements may be used if they provide due restoring force for the pedal assembly apparatus 100 to return to the original position when released from depression on the pad 125.

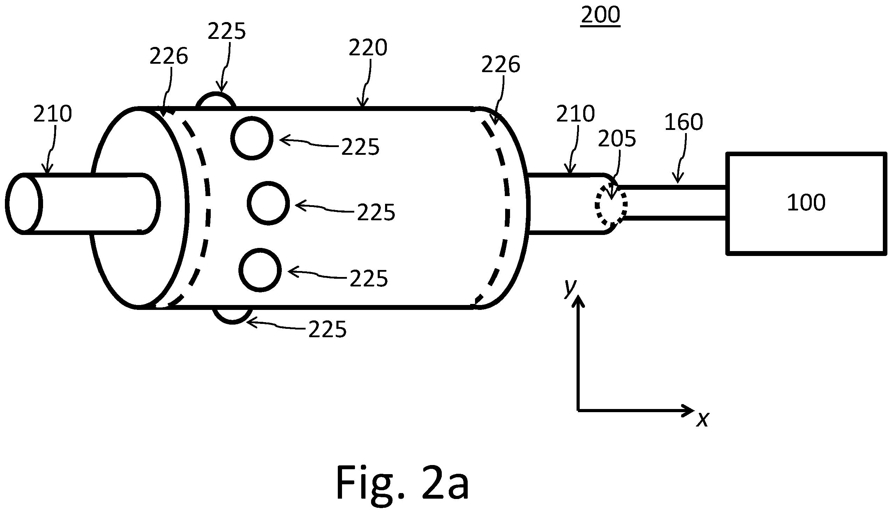

Fig. 2a shows the schematic of a motion conversion apparatus 200 connected to the pedal assembly apparatus 100. The motion conversion apparatus 200 comprises a shaft 210 and a rotatable cylinder 220. The push rod 160 of the pedal assembly 100 may be connected to the shaft 210 via a connection point 205. The connection point 205 may be arranged to guide the forward and backward movement of the shaft 210 in a linear motion, along the x-axis in Fig. 2a. In this respect, the term forward motion in the rest of the description relates to motion which originates from movement of the pad 125 against the spring 150 due to pressure from the user on the pad 125. The term backward motion relates to motion of the shaft 210 in the opposite direction, due to the retraction of pad 125 under pressure from the spring 150. The connection point 205 may be a rigid connection which is accomplished by, for example, welding the ends of the push rod 160 and the shaft 210 together. Alternatively, the connection point 205 may be a mechanical pivot, which may allow freedom in movement of the push rod 160. In other words, even when the motion of the push rod 160 is not confined in a linear motion which comprises the forward motion and the backward motion as defined above, the connection point 205 may be arranged to pivot such that the motion of the shaft 210 maybe confined to be in a linear motion. However, the implementation of the connection point 205 is not limited to these examples.

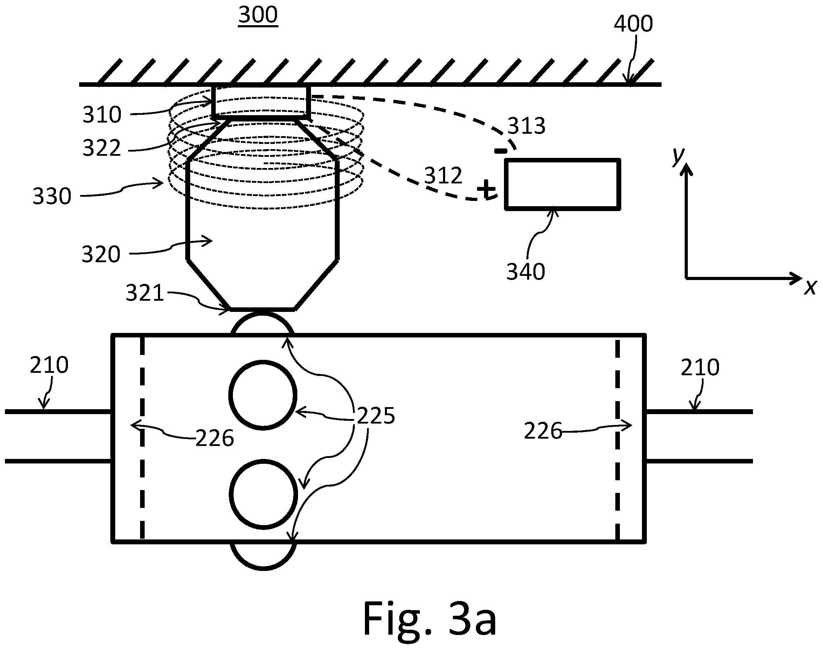

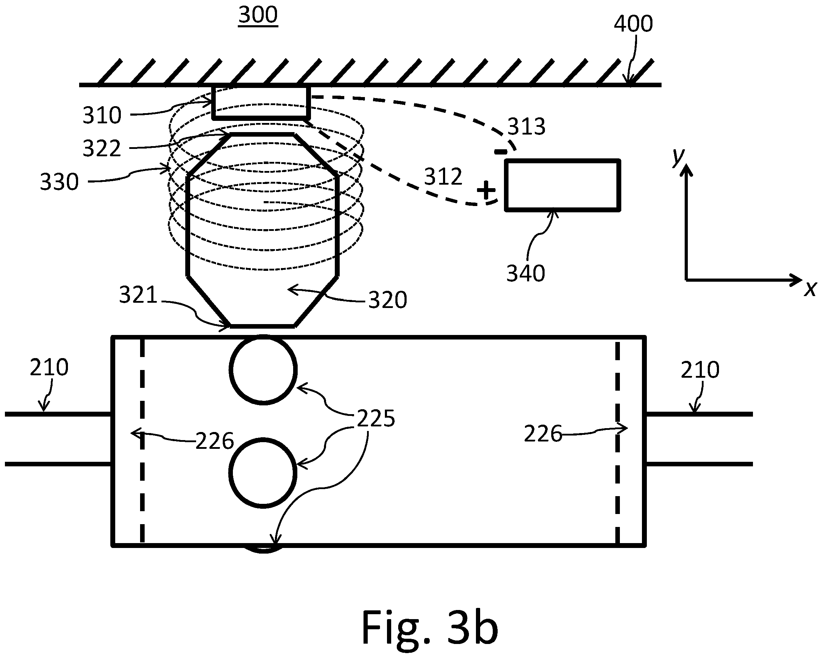

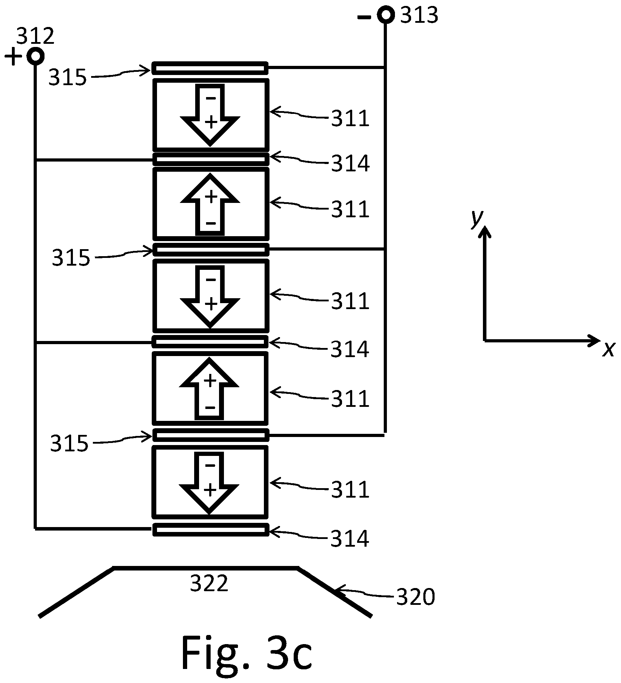

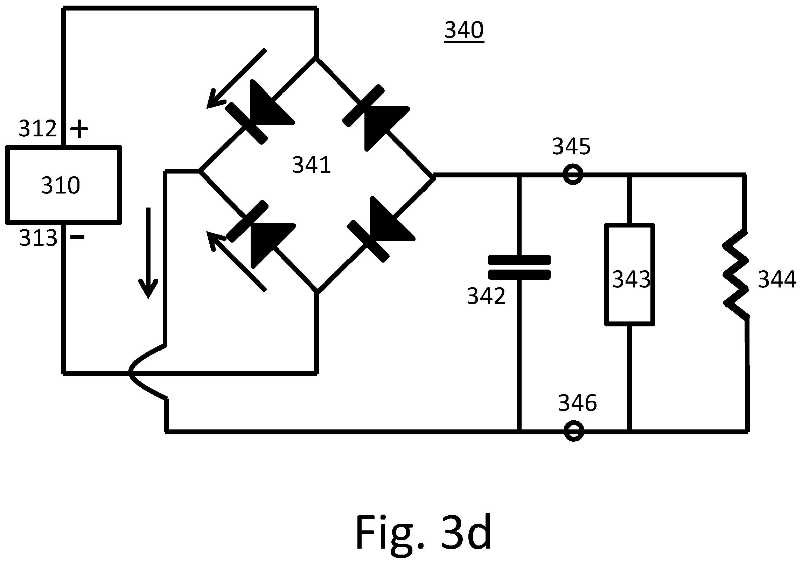

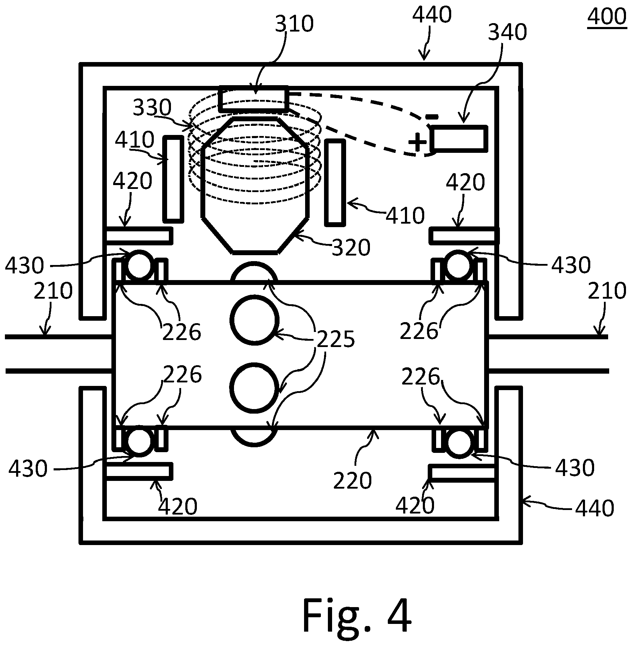

The rotatable cylinder 220 comprises an array of protrusions 225, spaced around the external circumferential surface of the rotatable cylinder 220. The spacing between the protrusions 225 may be regular, such that there is a predetermined distance interval between neighbouring protrusions 225. There may be more than one such array of these protrusions 225. The exact shape and position of the protrusions maybe determined for operation with a generation apparatus 300, which will be described in more detail below with respect to Fig. 3. The rotatable cylinder 220 may further comprise raceways 226 around the external circumferential surface of the cylinder 220 for guiding ball bearings on the exterior surface of the rotatable cylinder 220. This will be explained more in detail below with respect to Fig. 4. Alternatively, any other appropriate type of bearing may be used in place of ball bearings such as roller bearings, high super-precision bearings, or angular contact ball bearings. The kinds of bearings that may be used are not limited to these examples.

The shaft 210 and the rotatable cylinder 220 may be arranged such that linear motion of the shaft 210, for example along the x axis in Fig. 2a, is converted into rotational motion of the rotatable cylinder 220. In this way, it will be appreciated that movement of the pad 125, for example by the driver of the vehicle, causes rotation of the rotatable cylinder 220. A skilled person in the art will have access to various methods to achieve such linear to rotational motion conversion. Any of the methods available in the art may be applied as appropriate. Some of these methods may include motion conversion which involves low friction mechanical contact using a ball screw, a roller screw or a threadless ball screw, although the implementation of the motion conversion is not limited to these examples. In the implementation of the motion conversion between the shaft 210 and the rotatable cylinder 220, a mechanical contact between the shaft 210 and the rotatable cylinder 220 may not be necessary. For example, the rotatable cylinder 220 may be arranged to include an induction motor which operates in response to the movement of the shaft 210.

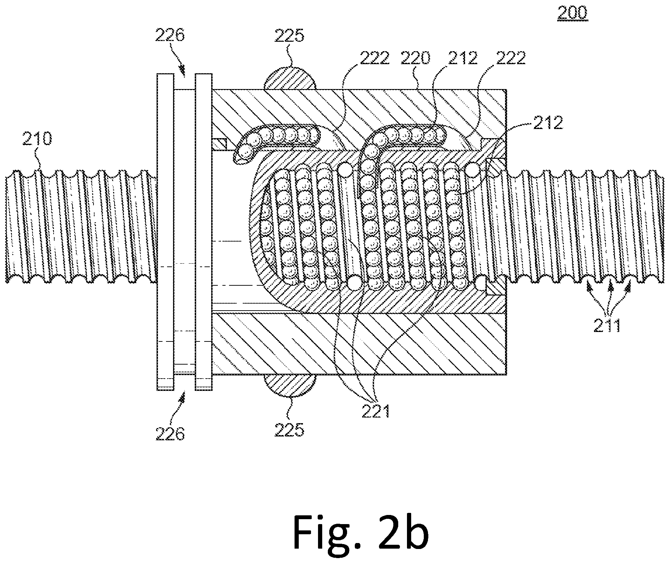

Fig. 2b shows one exemplary embodiment of the arrangement of the shaft 210 and the rotatable cylinder 220 to enable motion conversion. The internal structure of a part of the rotatable cylinder 220 is illustrated with respect to the shaft 210. In this exemplary embodiment, a ball screw is incorporated in the shaft 210 and the rotatable cylinder 220 to convert the linear motion of the shaft 210 into the rotational motion of the rotatable cylinder 220. The shaft 210 may comprise a helical raceway 211. The rotatable cylinder 220 may also comprise a helical raceway 221. A plurality of ball bearings 212 may be disposed in between the helical raceways 211, 221 and held in place by the helical raceways 211, 221. The ball bearings 212 may reduce rotational friction while supporting radial and axial loads such that the linear motion of the shaft 210 may be converted into the rotational motion of the rotatable cylinder 220 with minimum friction. The rotatable cylinder 220 may further comprise one or more return tubes 222 which are configured to return ball bearings 212 which have migrated along the raceways 211, 221 to one or more earlier portions of the raceways 211, 221. These earlier portions of the raceways 211, 221 may be portions of the grooves of the raceways 211, 221 disposed at a certain distance along the rotatable cylinder 220. The return tubes 222 may in this manner facilitate continuous operation of the motion conversion apparatus 200 with limited number of ball bearings 212. The exact geometry of raceways 211, 221 and the distance between them may be chosen and configured such that required rpm/mm ratio maybe achieved.

As discussed above, the arrangement of the shaft 210 and the rotatable cylinder 220 for motion conversion is not limited to this embodiment. As long as the linear motion of the shaft 210 can be efficiently converted into the rotational motion of the rotatable cylinder 220, any other embodiment may be appropriate.

Fig. 3a and 3b show the schematic of the generation apparatus 300 in conjunction with the motion conversion apparatus 200. The generation apparatus 300 comprises a piezo-transducer 310, a press rod 320, a spring 330 or other appropriate resilient member, and a harvesting circuit 340. The array of protrusions 225 of the rotatable cylinder 220 is arranged to be aligned with the press rod 320. For example, the protrusions 225 and the press rod 320 shown in Fig. 3a have approximately the same position on the x-axis of Fig. 3a. The alignment of the protrusions 225 and the press rod 320 causes the protrusions 225 to contact the press rod 320 as the rotatable cylinder 220 rotates. Each impact of one of the protrusions 225 on the press rod 320 causes a force to be exerted on the press rod 320.

As the rotatable cylinder 220 turns about the shaft 210, when one of the array of protrusions 225 is in contact with the press rod 320, the press rod 320 may apply pressure on the piezo-transducer 310. In this way, the press rod 320 acts to transfer energy from the rotating cylinder 220 to the piezo-transducer 310. The piezo-transducer 310 may be arranged to generate voltage in response to the mechanical compression or strain owing to the pressure from the press rod 320. In Fig. 3a, the relative y-axis positions of the piezo-transducer 310 and the press rod 320, and the height of respective ones of the protrusions 225 with respect to the bottom of the press rod 320, maybe such that piezo-transducer 310 generates voltage when the outermost point of one of the protrusions 225 is in contact with a first end 321 of the press rod 320, as shown in Fig. 3a. An optimal arrangement maybe determined depending on the desired application, for example to maximise the voltage generation or to ensure linear operation. The latter may be achieved when the mechanical compression of piezoelectric material of the piezo-transducer 310 is small enough to be in the linear regime. The optimal arrangements are not limited to these operations.

The shape of the protrusions 225 and the end 321 of the press rod 320 facing the protrusions 225 may be configured such that, as the rotatable cylinder 220 rotates, the protrusion 225 that is in mechanical contact with the end 321 of the press rod 320 may exert a pressure or strain on the rod 320 such that it causes a smooth and efficient movement of the press rod 320. For example, in Fig. 3a, a protrusion 225 striking the end 321 of the press rod 320 may cause a smooth and efficient movement of the press rod 320 along the y-axis. The surface of the protrusions 225 and the corresponding end surface of the press rod 320 may be arranged to be approximately hemi-spherical, although the surfaces are not limited to this example.

The surface of the protrusions 225 and the end 321 of the press rod 320 may be treated with material for reducing friction, or another material which may assist the mechanical contact between the two parts. The examples for the end 321 of the press rod 320 include anodising low friction coatings, graphite low friction coatings, MoS2 low friction coatings, plating low friction coatings, Teflon low friction coatings, thermal spray low friction coatings, vapor-deposition low friction coatings, and WS2 low friction coatings, although possible types of the materials are not limited to these examples.

The other end of the press rod 320, second end 322, for pressing the piezo-transducer 310, is configured to exert mechanical compression on the piezo-transducer 310. The mechanical compression may be exerted in a manner which is as controlled, consistent and efficient as possible. For example, the end 322 of the press rod 320 may comprise a resilient material that may ensure that the contact between the end 322 of the press rod 320 and the piezo-transducer 310 is uniform over a wide area and localised gaps between the end 322 of the press rod 320 and the surface of the piezo-transducer 310, which may be generated due to uneven contact between two surfaces, are minimised in case efficient compression of the piezo-transducer 310 is desired. The resilient material may be selected in dependence of factors such as the frequency of the operation such as the number of strikes per second by the end 322 of the press rod 320 and the choice of the piezoelectric material for the piezo-transducer 310. An example of a piezo-transducer is discussed below with respect to Fig. 4.

Fig. 3b shows a situation in which the press rod 320, in particular the first end 321 of the press rod 320, is released from contact with one of the protrusions 225. With the help of restoring force of the spring 330, the press rod 320 may under these conditions return to its original position. This entails the press rod 320 moving away from the piezo-transducer 310 and back towards the cylinder 220, since the rod 320 is no longer being forced towards the piezo-transducer 310 by contact with a protrusion 225. As such, under these conditions, the second end 322 of the press rod 320 may not be in mechanical contact with the piezo-transducer 310.

It will be appreciated that restoration of the press rod 320 to its original position could be facilitated by any suitable restoring member. In place of the spring 330, any other appropriate resilient element maybe used as long as the element provides due restoring force for the press rod 320 to return it to the original position. When the protrusion 225 and the press rod 320 are not in contact with each other, the piezo-transducer 310 does not generate any voltage.

Although Figs. 3a and 3b show embodiments in which there is provided a single generation apparatus 300 in operation with a single array of protrusions 225, it is not necessary to limit the number of generating apparatuses to one. There may be a plurality of generation apparatuses 300, for example comprising a corresponding plurality of arrays of protrusions 225 around the circumferential surface on the rotatable cylinder 220 or there may be a plurality of pairs of press rods 320 and piezo-transducers 310 operating with a single array of protrusions 225.

The piezo-transducer 310 and the spring 330 of the generation apparatus 300 may be fixed to a housing 400, which will be described later. The press rod 320 may be arranged such that its movement is limited to a linear motion, either toward or away from the piezo-transducer 310. A guiding structure 410 for the press rod 320, for example comprised as a part of the housing 400, may be provided for this purpose.

As mentioned above, the piezo-transducer 310 may be configured to generate voltage in response to the pressure or strain in a piezoelectric material. The exact voltage generated by the piezo-transducer 310 may depend on the microscopic structure of the used piezoelectric material, coverage area and the magnitude of the force applied. The skilled person will be able to choose the piezoelectric material considering the desired applications, cost and availability of materials and other engineering considerations. A skilled person will be also able to choose a suitable configuration of the piezo-transducer 310, such as the amount of piezoelectric material used and electrical wiring of the piezoelectric materials, depending on the desired application.

Fig. 3c shows an exemplary embodiment of the piezo-transducer 310. The piezo-transducer 310 may comprise a stack of multiple piezoelectric elements 311. Respective ones of the piezoelectric elements 311 may comprise a poled piezoelectric material, in which inherent electric dipole moments are on the average aligned into a specific direction. It is known in the art how to pole a known class of piezoelectric materials. In the example shown in Fig. 3c, the poling direction, represented by arrows within the piezoelectric element 311, is along the y-axis. Mechanical compression or strain on a poled piezoelectric element 311 changes the dipole moment, creating a voltage. Mechanical compression on the piezoelectric elements 311 along the poling direction and mechanical strain perpendicular to the poling direction may create a voltage of the same polarity as the poling voltage. Compression perpendicular to the poling direction and strain along the poling direction generates a voltage with polarity opposite that of the poling voltage. These actions may convert the mechanical energy of compression or tension, for example to due force from the press rod 320, into electrical energy. The voltage generated by compression and strain is linearly proportional to the applied force up to a point, at which the material is under stress. This point may be specific to each material.

The shape of each piezoelectric element 311 may include sheet, rod, disk or cube, although is not limited to these examples. The shape of the piezoelectric elements 311 may be chosen such that poling direction is well defined in the given geometry and a plurality of piezoelectric elements can be used together with good mechanical and electrical contact with one another. An example of a piezoelectric material for the piezoelectric element 311 is lead zirconate titanate (Pb(Zr,Ti)O3, PZT), a widely used material for energy harvesting. However, any other piezoelectric material can be used instead, including other ceramics such as barium titanate (BaTiO3) or piezoelectric crystals such as quartz (SiO2), berlinite (AlPO4), gallium orthophosphate (GaPo4). This list is not exhaustive.

In the embodiment shown in Fig. 3c, multiple piezoelectric elements 311 may be stacked on top of one another. By increasing the volume of the total piezoelectric material, the total electric energy that can be generated may also increase. The poling direction of respective ones of the piezoelectric elements 311 may be arranged to be aligned along a particular axis of the piezo-transducer 310, shown as the y-axis in Fig. 3c. However, the poling direction of respective ones of the piezoelectric elements 311 may alternate in polarity as shown in Fig. 3c such that an electrode may be shared by adjacent piezoelectric elements 311 for the same polarity. In the example in Fig. 3c, all of the positive electrodes 314 may be connected to a positive terminal 312 and all of the negative electrodes 315 may be connected to a negative terminal 313. In Fig. 3c, the piezoelectric elements 311 and the electrodes 314 and 315 are shown as not in mechanical and electrical contact for illustrative purpose. However, the elements 311 and electrodes 314, 315 may be arranged to be in secure contact with one another via electrically conductive glue, mechanical fastening or any other appropriate elements, when in operation. When compressive stress is applied from the press rod 320, voltage may be generated between the positive terminal 312 and the negative terminal 313. For example, when the number of the piezoelectric elements 311 is N, the voltage between the positive terminal 312 and the negative terminal 313 may be N times smaller than that of a single piezoelectric element 311, while the current flowing may be N times larger than that of a single piezoelectric element 311. Fig. 3c shows an example where N is 5, but N is not limited to this number.

Fig. 3c represent only one of the possible embodiments of the piezo-transducer 310 and depending on the desired application, other configurations may be adopted. For example, respective ones of the piezoelectric elements 311 may be connected in series to maximise the voltage output, or any other configuration of wiring of electrodes may be used to maximise a parameter of interest, such as the product of current and voltage depending on the number N.

The example shown in Fig. 3c is arranged to generate voltage upon substantially linear compression of the piezoelectric material in the transducer 310. However, as an alternative example, the piezo-transducer 310 may be arranged such that the pressure exerted on the piezo-transducer 310, for example due to the interaction between the press rod 320 and the protrusions 225 referred to above, leads to bending of the piezoelectric elements 311. In such an implementation, one or more layers of the piezoelectric elements 311 may be stacked and wired as desired, as discussed above. One end of the stack of the piezoelectric elements 311 may be fixed to the housing 400 and shaped, for example, as a cantilever, or any other suitable configurations to allow bending. The housing 400 may also be used for electrical grounding when necessary. The press rod 320 may be arranged to exert pressure on the end of the cantilever such that the stack of the piezoelectric elements 311 is bent. In this example, the generation apparatus 300 may also be arranged such that the press rod 320 and the spring 330 are omitted and such that the stack of piezoelectric elements 311 is bent when one of the protrusion units 225 is in direct contact with the piezo-transducer 310.

Alternatively, to the examples described above, the piezo-transducer 310 may comprise a single piezoelectric element 311.

As the rotatable cylinder 220 turns, the configurations shown in Figs. 3a and 3b occur in an alternating fashion. As a result, the piezo-transducer 310 may generate an oscillating voltage. The generated electrical energy may be harvested for use in the vehicle by providing a harvesting circuit 340.

Fig. 3d shows an example embodiment of a harvesting circuit 340. When the piezo-transducer 310 generates oscillating voltage (AC voltage), for example in the manner described above, the corresponding current may be rendered to flow in a particular direction by a rectifier 341 in the circuit 340. This is shown by arrows in Fig. 3d. The electric current may be smoothed by a capacitor 342. The combination of the rectifier 341 and the capacitor 342, which is connected across the output terminals of the rectifier 341, may function as a current source to a load 344 connected in parallel to the capacitor 342 at the terminals 345, 346. For example, a rechargeable battery connected to the terminals 345, 346 as the load 344 may be charged to store energy generated by the piezo-transducer 310. For another example, a light emitting diode, which could for example be used as a dashboard indicator, may be operated by being connected as the load 344 to the terminals 345, 346. A constant voltage circuit 343 may be additionally appended in parallel to the capacitor 342 and the load 344 to be used as a voltage source such that voltage may be supplied to a load 344. The load 344 may be any other appropriate equipment which may use the electrical energy generated at the piezo-transducer 310.

The housing apparatus 400 will now be described in more detail below.

Fig. 4 shows the schematic of the housing apparatus 400 in combination with the motion conversion apparatus 200 and the generation apparatus 300. The housing apparatus 400 comprises the guiding structure 410, raceways 420, ball bearings 430, and a housing body 440. The housing body 440 encloses a part of the motion conversion apparatus 200 and the whole of the generation apparatus 300. The guiding structure 410, as mentioned above, guides the linear motion of the press rod 320.

The housing apparatus 400 may be configured to ensure that the motion of the rotatable cylinder 220 is limited to a rotational motion only and to ensure that the rotational motion of the rotatable cylinder 220 is stable and with minimum friction. In other words, the housing apparatus 400 may be arranged to ensure that the linear motion of the shaft 210 is converted to the rotational motion of the rotatable cylinder 220 in an efficient manner. For this purpose, the raceways 226, 420 and the ball bearings 430 may be provided. The ball bearings 430 may be disposed between the raceways 226 on the cylinder 220 and the raceways 420 on the body 440 of the housing apparatus 400 such that the movement of the rotatable cylinder 220 is limited to a rotational motion and such that the rotational motion undergoes minimum possible friction. Any other appropriate type of bearing may be used in place of ball bearings 430 such as roller bearings, high super-precision bearings, and angular contact ball bearings. The kinds of bearings that may be used are not limited to these examples.

As discussed above, when the piezo-transducer 310 is arranged such that voltage is generated by bending of the piezoelectric elements 311, the press rod 320 and the spring 330 may be omitted. In such a case, the guiding structure 410 may also be omitted from the housing apparatus 400. The housing apparatus 400 may be adjusted to accommodate the motion conversion apparatus 200 and the generation apparatus 300 such that the pressure applied on the pedal assembly apparatus 100 by a driver of the vehicle may be efficiently converted into generation of electric energy at the piezo-transducer 310.

The embodiments of the invention shown in the drawings and described above are exemplary embodiments only and are not intended to limit the scope of the invention, which is defined by the claims hereafter.

## Claims

1. A pedal assembly (100) for generating electrical power in a vehicle, comprising:
a pedal comprising a pad (125) and a push element (160), the pedal configured to mechanically transfer pressure exerted on the pad to the push element to cause motion of the push element;
a motion conversion apparatus (200) comprising a shaft (210) and a rotatable cylinder (220),
the motion conversion apparatus configured, in response to the motion of the push element, to generate a linear motion of the shaft along a longitudinal direction (x) of the shaft,
the motion conversion apparatus further configured, in response to the linear motion of the shaft, to rotate the rotatable cylinder about the shaft; and
a generation apparatus (300) for generating voltage comprising a piezoelectric transducer (310),
wherein the rotatable cylinder is configured to apply mechanical stress on the piezoelectric transducer at at least one predetermined angular position of the rotatable cylinder.

2. A pedal assembly according to claim 1,
wherein the rotatable cylinder further comprises a plurality of protrusions (225) positioned at the predetermined angular position along a circumference of the rotatable cylinder.

3. A pedal assembly according to claim 2,
wherein the generation apparatus further comprises a press element (320),
wherein at the protrusions are configured to be in mechanical contact with the press element at the predetermined angular positions of the rotatable cylinder such that the press element applies mechanical stress on the piezoelectric transducer when the at least one of the protrusions is in mechanical contact with the press element,
optionally wherein the generation apparatus further comprises a first resilient apparatus (322) configured to bring the press element back to a default position when the protrusions are not in mechanical contact with the press element.

4. A pedal assembly according to claim 2,
wherein the protrusions are configured to be in mechanical contact with the piezoelectric transducer at the predetermined angular positions such that the protrusions apply mechanical stress on the piezoelectric transducer when at least one of the protrusions is in mechanical contact with the piezoelectric transducer.

5. A pedal assembly according to any one of claims 2 to 4, wherein the predetermined angular positions of the protrusions around the circumference of the rotatable cylinder are substantially uniformly spaced such that the voltage generated by the generation apparatus oscillates,
optionally wherein a period of oscillation of the generated voltage is dependent on the predetermined angular positions of the protrusions and a frequency of rotation of the rotatable cylinder.

6. A pedal assembly according to any one of the preceding claims,
wherein the rotatable cylinder further comprises a first helical raceway (221) and the shaft further comprises a second helical raceway (211),
wherein the motion conversion apparatus further comprises a plurality of bearings (212) which are arranged to be disposed between the first and second helical raceways,
wherein the rotatable cylinder is arranged to rotate in response to linear motion of the shaft in cooperation with the plurality of bearings guided by the first and second raceways.

7. A pedal assembly according to claim 6, wherein the plurality of bearings comprises ball bearings, or high super-precision bearings, or angular contact ball bearings.

8. A pedal assembly according to claim 6, wherein the plurality of bearings comprise roller bearings.

9. A pedal assembly according to any one of the preceding claims, further comprising a housing (400),
wherein the piezoelectric transducer is fixed to the housing.

10. A pedal assembly according to claim 9,
wherein the housing further comprises third and fourth raceways (420); and the rotatable cylinder further comprises fifth and sixth raceways (226) on an exterior of the rotatable cylinder,
wherein ball bearings (430) are disposed and held between the third and fifth raceways and fourth and sixth raceways, respectively, such that the motion of the rotatable cylinder is guided to be rotational with respect to the housing.

11. A pedal assembly according to any one of the preceding claims, wherein the piezoelectric transducer comprises a stack of multiple layers (311) of piezoelectric material.

12. A pedal assembly according to any one of the preceding claims, wherein the mechanical stress on the piezoelectric transducer comprises mechanical compression.

13. A pedal assembly according to any one of the preceding claims, wherein the mechanical stress on the piezoelectric transducer comprises mechanical strain.

14. A pedal assembly according to any one of the preceding claims, further comprising a harvesting circuit (340), which comprises a rectifier (341) and a capacitor (342).

15. A pedal assembly according to any one of the preceding claims, wherein the pedal assembly further comprises a second resilient apparatus (150) configured to bring the pad back to a default position when no pressure is exerted on the pad.

## Patentansprüche

1. Pedalanordnung (100) zum Erzeugen von elektrischer Leistung in einem Fahrzeug, die Folgendes umfasst:
ein Pedal, umfassend eine Platte (125) und ein Drückelement (160), wobei das Pedal dazu ausgelegt ist, Druck, der auf die Platte gewirkt wird, mechanisch zum Drückelement zu übertragen, um Bewegung des Drückelements zu veranlassen;
eine Bewegungsumwandlungseinrichtung (200), umfassend eine Welle (210) und einen drehbaren Zylinder (220),
wobei die Bewegungsumwandlungseinrichtung dazu ausgelegt ist, in Reaktion auf die Bewegung des Drückelements, eine lineare Bewegung der Welle entlang einer Längsrichtung (X) der Welle zu erzeugen,
wobei die Bewegungsumwandlungseinrichtung ferner dazu ausgelegt ist, in Reaktion auf die lineare Bewegung der Welle, den drehbaren Zylinder um die Welle zu drehen; und
wobei eine Erzeugungseinrichtung (300) zum Erzeugen von Spannung einen piezoelektrischen Wandler (310) umfasst,
wobei der drehbare Zylinder dazu ausgelegt ist, bei zumindest einer vorbestimmten Winkelposition des drehbaren Zylinders mechanische Spannung auf den piezoelektrischen Wandler auszuüben.

2. Pedalanordnung nach Anspruch 1,
wobei der drehbare Zylinder ferner mehrere Vorsprünge (225) umfasst, die an vorbestimmten Winkelpositionen entlang eines Umfangs des drehbaren Zylinders positioniert sind.

3. Pedalanordnung nach Anspruch 2,
wobei die Erzeugungseinrichtung ferner ein Presselement (320) umfasst,
wobei bei die Vorsprünge dazu ausgelegt sind, an den vorbestimmten Winkelpositionen des drehbaren Zylinders in mechanischem Kontakt mit dem Presselement zu sein, sodass das Presselement mechanische Spannung auf den piezoelektrischen Wandler ausübt, wenn der zumindest eine der Vorsprünge in mechanischem Kontakt mit dem Presselement ist,
wobei optional die Erzeugungseinrichtung ferner eine erste elastische Einrichtung (322) umfasst, die dazu ausgelegt ist, das Presselement wieder in eine Standardposition zurückzubringen, wenn die Vorsprünge nicht in mechanischem Kontakt mit dem Presselement sind.

4. Pedalanordnung nach Anspruch 2,
wobei die Vorsprünge dazu ausgelegt sind, an den vorbestimmten Winkelpositionen in mechanischem Kontakt mit dem piezoelektrischen Wandler zu sein, sodass die Vorsprünge mechanische Spannung auf den piezoelektrischen Wandler ausüben, wenn zumindest einer der Vorsprünge in mechanischem Kontakt mit dem piezoelektrischen Wandler ist.

5. Pedalanordnung nach einem der Ansprüche 2 bis 4,
wobei die vorbestimmten Winkelpositionen der Vorsprünge rund um den Umfang des drehbaren Zylinders im Wesentlichen gleichmäßig beabstandet sind, sodass die durch die Erzeugungseinrichtung erzeugte Spannung oszilliert,
wobei optional eine Periode von Oszillation der erzeugten Spannung von den vorbestimmten Winkelpositionen der Vorsprünge und einer Drehfrequenz des drehbaren Zylinders abhängig ist.

6. Pedalanordnung nach einem der vorhergehenden Ansprüche,
wobei der drehbare Zylinder ferner eine erste schraubenförmige Laufbahn (221) umfasst und die Welle ferner eine zweite schraubenförmige Laufbahn (211) umfasst,
wobei die Bewegungsumwandlungseinrichtung ferner mehrere Lager (212) umfasst, die angeordnet sind, um zwischen der ersten und der zweiten schraubenförmigen Laufbahn angeordnet zu werden,
wobei der drehbare Zylinder angeordnet ist, um sich in Reaktion auf lineare Bewegung der Welle in Zusammenwirken mit den mehreren Lagern zu drehen, geführt durch die erste und die zweite Laufbahn.

7. Pedalanordnung nach Anspruch 6, wobei die mehreren Lager Kugellager oder Hochgenauigkeitslager oder Schrägkugellager umfassen.

8. Pedalanordnung nach Anspruch 6, wobei die mehreren Lager Rollenlager umfassen.

9. Pedalanordnung nach einem der vorhergehenden Ansprüche, ferner umfassend ein Gehäuse (400),
wobei der piezoelektrische Wandler am Gehäuse befestigt ist.

10. Pedalanordnung nach Anspruch 9,
wobei das Gehäuse ferner dritte und vierte Laufbahnen (420) umfasst; und wobei der drehbare Zylinder ferner fünfte und sechste Laufbahnen (226) an einer Außenseite des drehbaren Zylinders umfasst,
wobei Kugellager (430) zwischen der dritten und fünften Laufbahn bzw. der vierten und sechsten Laufbahn angeordnet sind und gehalten werden, sodass die Bewegung des drehbaren Zylinders geführt wird, um bezüglich des Gehäuses rotatorisch zu sein.

11. Pedalanordnung nach einem der vorhergehenden Ansprüche, wobei der piezoelektrische Wandler einen Stapel aus mehreren Schichten (311) von piezoelektrischem Material umfasst.

12. Pedalanordnung nach einem der vorhergehenden Ansprüche, wobei die mechanische Spannung auf dem piezoelektrischen Wandler mechanische Kompression umfasst.

13. Pedalanordnung nach einem der vorhergehenden Ansprüche, wobei die mechanische Spannung auf dem piezoelektrischen Wandler mechanischen Zug umfasst.

14. Pedalanordnung nach einem der vorhergehenden Ansprüche, ferner umfassend eine Gewinnungsschaltung (340), die einen Gleichrichter (341) und einen Kondensator (342) umfasst.

15. Pedalanordnung nach einem der vorhergehenden Ansprüche, wobei die Pedalanordnung ferner eine zweite elastische Einrichtung (150) umfasst, die dazu ausgelegt ist, die Platte in eine Standardposition zurückzubringen, wenn kein Druck auf die Platte ausgeübt wird.

## Revendications

1. Ensemble pédale (100) pour générer de l'énergie électrique dans un véhicule, comprenant :
une pédale comprenant un patin (125) et un élément de poussée (160), la pédale étant configurée pour transférer mécaniquement une pression exercée sur le patin vers l'élément de poussée afin de provoquer un mouvement de l'élément de poussée ;
un appareil de conversion de mouvement (200) comprenant un arbre (210) et un cylindre rotatif (220),
l'appareil de conversion de mouvement étant configuré, en réaction au mouvement de l'élément de poussée, pour générer un mouvement linéaire de l'arbre le long d'un sens longitudinal (x) de l'arbre,
l'appareil de conversion de mouvement étant configuré en outre, en réaction au mouvement linéaire de l'arbre, pour faire tourner le cylindre rotatif autour de l'arbre ; et
un appareil de génération (300) pour générer une tension comprenant un transducteur piézo-électrique (310),
dans lequel le cylindre rotatif est configuré pour appliquer une sollicitation mécanique sur le transducteur piézo-électrique au niveau d'au moins une position angulaire prédéterminée du cylindre rotatif.

2. Ensemble pédale selon la revendication 1,
dans lequel le cylindre rotatif comprend en outre une pluralité de saillies (225) positionnées au niveau de la position angulaire prédéterminée le long d'une circonférence du cylindre rotatif.

3. Ensemble pédale selon la revendication 2,
dans lequel l'appareil de génération comprend en outre un élément de pression (320),
dans lequel à les saillies sont configurées pour être en contact mécanique avec l'élément de pression au niveau des positions angulaires prédéterminées du cylindre rotatif de telle sorte que l'élément de pression applique une sollicitation mécanique sur le transducteur piézo-électrique lorsque l'au moins une des saillies est en contact mécanique avec l'élément de pression,
facultativement l'appareil de génération comprenant en outre un premier appareil élastique (322) configuré pour ramener l'élément de pression en arrière jusqu'à une position de défaut lorsque les saillies ne sont pas en contact mécanique avec l'élément de pression.

4. Ensemble pédale selon la revendication 2,
dans lequel les saillies sont configurées pour être en contact mécanique avec le transducteur piézo-électrique au niveau des positions angulaires prédéterminées de telle sorte que les saillies appliquent une sollicitation mécanique sur le transducteur piézo-électrique lorsque l'au moins une des saillies est en contact mécanique avec le transducteur piézo-électrique.

5. Ensemble pédale selon l'une quelconque des revendications 2 à 4, dans lequel les positions angulaires prédéterminées des saillies autour de la circonférence du cylindre rotatif sont espacées substantiellement de manière uniforme de telle sorte que la tension générée par l'appareil de génération oscille,
facultativement dans lequel une période d'oscillation de la tension générée est dépendante des positions angulaires prédéterminées des saillies et d'une fréquence de rotation du cylindre rotatif.

6. Ensemble pédale selon l'une quelconque des revendications précédentes,
dans lequel le cylindre rotatif comprend en outre un premier chemin de roulement hélicoïdal (221) et l'arbre comprend en outre un deuxième chemin de roulement hélicoïdal (211),
dans lequel l'appareil de conversion de mouvement comprend en outre une pluralité de paliers (212) qui sont agencés pour être disposés entre les premier et deuxième chemins de roulement hélicoïdaux,
dans lequel le cylindre rotatif est agencé pour tourner en réaction à un mouvement linéaire de l'arbre en coopération avec la pluralité de paliers guidés par les premier et deuxième chemins de roulement.

7. Ensemble pédale selon la revendication 6, dans lequel la pluralité de paliers comprend des roulements à billes, ou des roulements de super-précision élevée, ou des roulements à billes à contact angulaire.

8. Ensemble pédale selon la revendication 6, dans lequel la pluralité de paliers comprend des roulements à rouleaux.

9. Ensemble pédale selon l'une quelconque des revendications précédentes, comprenant en outre un logement (400),
dans lequel le transducteur piézo-électrique est fixé au logement.

10. Ensemble pédale selon la revendication 9,
dans lequel le logement comprend en outre des troisième et quatrième chemins de roulement (420) ; et le cylindre rotatif comprend en outre des cinquième et sixième chemins de roulement (226) sur une face extérieure du cylindre rotatif,
dans lequel des roulements à billes (430) sont disposés et maintenus entre les troisième et cinquième chemins de roulement et quatrième et sixième chemins de roulement, respectivement, de telle sorte que le mouvement du cylindre rotatif soit guidé pour qu'il soit rotationnel par rapport au logement.

11. Ensemble pédale selon l'une quelconque des revendications précédentes, dans lequel le transducteur piézo-électrique comprend un empilement de couches multiples (311) en matériau piézo-électrique.

12. Ensemble pédale selon l'une quelconque des revendications précédentes, dans lequel la sollicitation mécanique sur le transducteur piézo-électrique comprend une compression mécanique.

13. Ensemble pédale selon l'une quelconque des revendications précédentes, dans lequel la sollicitation mécanique sur le transducteur piézo-électrique comprend une contrainte mécanique.

14. Ensemble pédale selon l'une quelconque des revendications précédentes, comprenant en outre un circuit collecteur (340), qui comprend un redresseur (341) et un condensateur (342).

15. Ensemble pédale selon l'une quelconque des revendications précédentes, l'ensemble pédale comprenant en outre un deuxième appareil élastique (150) configuré pour ramener le patin en arrière jusqu'à une position de défaut lorsqu'aucune pression n'est exercée sur le patin.
